(19) Europäisches Patentamt
European Patent Office
Office européen des brevets

(11) EP 4 549 517 A1

(12) # EUROPEAN PATENT APPLICATION
published in accordance with Art. 153(4) EPC

(43) Date of publication:
**07.05.2025 Bulletin 2025/19**

(21) Application number: **23831051.0**

(22) Date of filing: **12.06.2023**

(51) International Patent Classification (IPC):
***C08L 101/00*** (2006.01) ***C08L 79/08*** (2006.01)
***C08K 3/013*** (2018.01) ***C08K 3/22*** (2006.01)

(52) Cooperative Patent Classification (CPC):
**C08K 3/013; C08K 3/22; C08L 79/08; C08L 101/00**

(86) International application number:
**PCT/JP2023/021667**

(87) International publication number:
**WO 2024/004602 (04.01.2024 Gazette 2024/01)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.06.2022 JP 2022103714**

(71) Applicant: **MITSUBISHI GAS CHEMICAL COMPANY, INC.**
**Chiyoda-ku**
**Tokyo 100-8324 (JP)**

(72) Inventor: **SATO Yuuki**
**Hiratsuka-shi, Kanagawa 254-0016 (JP)**

(74) Representative: **Vossius & Partner**
**Patentanwälte Rechtsanwälte mbB**
**Siebertstrasse 3**
**81675 München (DE)**

(54) **THERMOPLASTIC RESIN COMPOSITION, MOLDED BODY, AND CONSTITUTING MEMBER OF IC SOCKET FOR INSPECTION**

(57) A thermoplastic resin composition containing a component (A), which is at least one thermoplastic resin selected from the group consisting of a crystalline thermoplastic resin (a1) having a melting point of 270°C or more and an amorphous thermoplastic resin (a2) having a glass transition temperature of 200°C or more, and a component (B), which is an inorganic filler including a zirconium oxide (b1), wherein the content of the component (b1) is 2 to 40 parts by mass with respect to 100 parts by mass of the component (A), and the content of the component (B) is 2 to 60 parts by mass based on 100 parts by mass of the component (A).

EP 4 549 517 A1

## Description

### Technical Field

The present invention relates to a thermoplastic resin composition, a molded article, and a component part of an IC socket for inspection.

### Background Art

Engineering plastics are thermoplastic resins that have various excellent properties such as formability, heat resistance, and strength, and are used in a wide range of fields such as automobile parts, mechanical parts, and electrical and electronic parts.

Thermoplastic resin compositions containing a functional filler are also known as engineering plastics. For example, Patent Literature 1 describes that a low-contamination injection-molded article formed from a resin composition formed containing predetermined amounts of each of a thermoplastic resin component containing a crystalline thermoplastic resin and an amorphous thermoplastic resin, a carbon precursor, and a conductive filler is capable of strictly controlling surface resistivity to a desired value within the semiconductive region, and that the amount of foreign particles generated is extremely small.

Patent Literature 2 discloses that a flame-retardant polyimide molding material containing a semi-aromatic polyimide resin and predetermined amounts of graphite, carbon fiber, and the like has excellent formability and can exhibit high flame retardancy.

Moreover, a test socket used to inspect the electrical characteristics of a semiconductor/device and test whether the desired specifications are satisfied is known (for example, see Patent Literature 3). Patent Literature 3 discloses that the ball guide film 180 constituting the test socket can be composed of a polyimide film that is thin and has excellent wear resistance.

### Citation List

### Patent Literature

PTL 1: JP2005-290328 A
PTL 2: WO 2021/024624 A1
PTL 3: JP 2018-529932 A


## Summary of Invention

### Technical Problem

It is also described that the flame-retardant polyimide molding material described in Patent Literature 2 can be applied to an IC socket for inspection. Examples of the IC socket for inspection include IC sockets for product inspection (test sockets), IC sockets for burn-in tests (burn-in sockets), and the like. There are many members that make up these IC sockets for inspection, but the member to which the flame-retardant polyimide molding material can be applied is, for example, a substantially flat plate-like member used at a site where the device to be inspected is mounted. Examples of methods for producing such a member using a molded article containing a thermoplastic resin and inorganic filler, such as the flame-retardant polyimide molding material, include a method of machining the molded article to produce a flat plate, and drilling fine through holes into which the measurement device is to be fitted.

However, with the conventional technology, there is room for further improvement in the machining processability of the molded article and in the microfabricability when producing a component part of an IC socket for inspection using a flat plate obtained by a machining process. For example, regarding the machining processability of molded articles, there is a problem in that when a molded article produced by injection-molding or the like is subjected to a machining process, if the obtained flat-plate surface has large asperities, the molded article is not suitable for microfabrication. Regarding microfabricability, when a large number of through holes are formed at a narrow pitch in the obtained flat plate, if there is an increase in the hole diameter distribution, or if pattern collapse, burrs, or the like occur, the molded article is not suitable for producing a component part of IC socket for inspection.

An object of the present invention is to provide a thermoplastic resin composition that can produce a molded article having excellent machining processability and microfabricability.

Solution to Problem

The present inventors have found that the aforementioned object can be attained by a thermoplastic resin composition containing a specific thermoplastic resin and a specific inorganic filler.

That is, the present invention relates to the following.

[1] A thermoplastic resin composition containing:

a component (A), which is at least one thermoplastic resin selected from the group consisting of a crystalline thermoplastic resin (a1) having a melting point of 270°C or more and an amorphous thermoplastic resin (a2) having a glass transition temperature of 200°C or more; and

a component (B), which is an inorganic filler including a zirconium oxide (b1), wherein

the content of the component (b1) is 2 to 40 parts by mass with respect to 100 parts by mass of the component (A), and

the content of the component (B) is 2 to 60 parts by mass based on 100 parts by mass of the component (A).

[2] The thermoplastic resin composition according to the above [1], wherein the component (A) is at least one selected from the group consisting of a polyimide resin, a polyetherimide resin, a polyetherimide sulfone resin, a polyphenylene sulfide resin, a polyether ether ketone resin, a polyether ketone ketone resin, a liquid crystal polymer, and a wholly aromatic polyester resin other than a liquid crystal polymer.

[3] The thermoplastic resin composition according to the above [1] or [2], wherein the component (A) includes a polyimide resin (al-1) containing a repeating structural unit represented by the following formula (1) and a repeating structural unit represented by the following formula (2), a content ratio of the repeating structural unit of formula (1) to the total of the repeating structural unit of formula (1) and the repeating structural unit of formula (2) being 20 to 70 mol%:

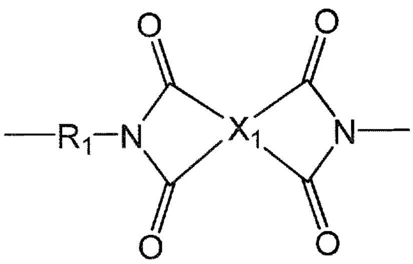

(1)

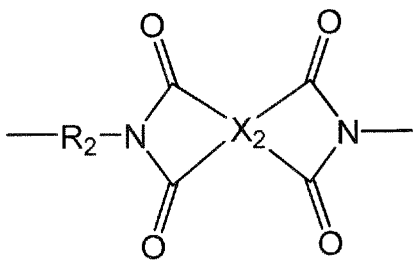

(2)

wherein $R_1$ represents a divalent group having from 6 to 22 carbon atoms containing at least one alicyclic hydrocarbon structure; $R_2$ represents a divalent chain aliphatic group having from 5 to 16 carbon atoms; and $X_1$ and $X_2$ each independently represent a tetravalent group having from 6 to 22 carbon atoms containing at least one aromatic ring.

[4] The thermoplastic resin composition according to any one of the above [1] to [3], wherein the component (b1) has a volume median diameter (D50) of 1 μm or less.

[5] The thermoplastic resin composition according to any one of the above [1] to [4], wherein the component (b1) is a spherical particle.

[6] The thermoplastic resin composition according to any one of the above [1] to [5], wherein the component (B) further includes an inorganic filler (b2) other than the component (b1), and the component (b2) is at least one selected from the group consisting of talc, mica, silica, alumina, silicon nitride, aluminum nitride, boron nitride, silicon carbide, boron carbide, calcium carbonate, and titanium oxide.

[7] The thermoplastic resin composition according to the above [6], wherein the content of the component (b2) is 1 to 40 parts by mass with respect to 100 parts by mass of the component (A).

[8] A molded article including the thermoplastic resin composition according to any one of the above [1] to [7].

[9] A component part of an IC socket for inspection obtained by processing the molded article according to the above [8].

Advantageous Effects of Invention

According to the thermoplastic resin composition of the present invention, a molded article having excellent

machining processability and microfabricability can be produced. The molded article is suitable for producing, for example, a component part of an IC socket for inspection.

Brief Description of Drawings

[Fig. 1] Fig. 1 is a schematic plan view showing an embodiment of a component part 100 of an IC socket for inspection.

Description of Embodiments

[Definitions]

As used herein, "a molded article having excellent machining processability" means that when a flat plate-like molded article (hereinafter also simply referred to as "flat plate") is produced by thermoforming a thermoplastic resin composition to obtain a molded article, and subjecting the obtained molded article to a machining process, a flat plate with low surface roughness on the machining-processed surface can be obtained. Surface roughness can be evaluated based on arithmetic average roughness (Ra). Further, if the flat plate obtained by the machining process has little warpage, the molded article is determined as having better machining processability.

As used herein, "a molded article having excellent microfabricability" means that when a large number of through holes are formed at a narrow pitch on the flat plate, there is little variation in hole diameter, and the through holes have a good appearance with less pattern collapse, occurrence of burrs, and the like. As used herein, "through hole" means a fine through hole having a diameter of, for example, 200 $\mu$m or less, preferably 100 $\mu$m or less, and more preferably less than 100 $\mu$m, and a pitch of, for example, in the range of 1 to 5 times the diameter of the through hole.

Machining processability and microfabricability can be specifically evaluated by the methods described in the examples.

[Thermoplastic resin composition]

The thermoplastic resin composition of the present invention contains a component (A), which is at least one thermoplastic resin selected from the group consisting of a crystalline thermoplastic resin (a1) having a melting point of 270°C or more and an amorphous thermoplastic resin (a2) having a glass transition temperature of 200°C or more, and a component (B), which is an inorganic filler including a zirconium oxide (b1), wherein the content of the component (b1) is 2 to 40 parts by mass with respect to 100 parts by mass of the component (A), and the content of the component (B) is 2 to 60 parts by mass based on 100 parts by mass of the component (A).

The thermoplastic resin composition of the present invention can produce a molded article having excellent machining processability and microfabricability by using a thermoplastic resin (A) having predetermined thermophysical properties and a predetermined amount of an inorganic filler (B) including zirconium oxide (b1). As described later, the zirconium oxide (b1) preferably has a volume median diameter (D50) of 1 $\mu$m or less.

Although the reason why the above effects are obtained in the present invention is not clear, it is presumed that by using submicron-level fine zirconium oxide (b1) particles as an inorganic filler, asperities caused by particles present on the machined surface are suppressed, enabling a low surface roughness to be achieved. In addition, it is thought that when fine through holes are formed in the molded article, the wall surfaces of the fine through holes are also kept smooth, which improves the precision of hole formation, suppresses an increase in the hole size distribution, and suppresses pattern collapse. It is presumed that by including a predetermined amount of a high-hardness component (b1) relative to the thermoplastic resin (A), the material becomes appropriately brittle and the occurrence of burrs can be suppressed.

<Thermoplastic resin (A)>

The thermoplastic resin (A) used in the present invention (hereinafter also simply referred to as "component (A)" or "thermoplastic resin (A)") is at least one selected from the group consisting of a crystalline thermoplastic resin (a1) having a melting point of 270°C or more and an amorphous thermoplastic resin (a2) having a glass transition temperature of 200°C or more.

As used herein, "crystalline thermoplastic resin" refers to a resin that has a melting point and a glass transition temperature, and "amorphous thermoplastic resin" refers to a resin that has a glass transition temperature but does not have a melting point. It is noted that resins that are essentially crystalline but have an extremely slow crystallization rate, and can only be processed in an amorphous state using various forming methods, are classified as being an amorphous thermoplastic resin.

(Crystalline thermoplastic resin (a1))

The crystalline thermoplastic resin (a1) (hereinafter also simply referred to as "component (a1)") used as component (A) is a crystalline thermoplastic resin having a melting point of 270°C or more, from the viewpoint of producing a molded article having excellent machining processability and microfabricability.

The melting point of the component (a1) is preferably 280°C or more, more preferably 290°C or more, and further preferably 300°C or more, from the viewpoint of improving the machining processability and microfabricability of the obtained molded article. In addition, the melting point is preferably 400°C or less, more preferably 380°C or less, and further preferably 350°C or less, from the viewpoint of ease of thermoforming.

The melting point of the component (a1) can be measured using a differential scanning calorimeter, and specifically by the method described in the examples.

The glass transition temperature (Tg) of the component (a1) is not particularly limited, but is preferably 130°C or more, more preferably 140°C or more, and further preferably 150°C or more, and from the viewpoint of ease of forming, is preferably 250°C or less, more preferably 230°C or less, and further preferably 200°C or less, from the viewpoint of improving the machining processability and microfabricability of the obtained molded article.

The glass transition temperature of the component (a1) can be measured using a differential scanning calorimeter, and specifically by the method described in the examples.

(Amorphous thermoplastic resin (a2))

The amorphous thermoplastic resin (a2) (hereinafter also simply referred to as "component (a2)") used as component (A) is an amorphous thermoplastic resin having a glass transition temperature of 200°C or more from the viewpoint of producing a molded article having excellent machining processability and microfabricability.

The glass transition temperature (Tg) of the component (a2) is preferably 210°C or more, more preferably 230°C or more, and further preferably 250°C or more, from the viewpoint of improving the machining processability and microfabricability of the obtained molded article. Further, the glass transition temperature is preferably 400°C or less, more preferably 350°C or less, and further preferably 300°C or less, from the viewpoint of ease of thermoforming.

The glass transition temperature of the component (a2) can be measured by the same method as described above.

Examples of the component (A) include thermoplastic resins that fall under either of the component (a1) or component (a2) among a polyimide resin, a polyamide resin, a polyetherimide resin, a polyetherimide sulfone resin, a polyphenylene sulfide resin, a polyether ether ketone resin, a polyether ketone ketone resin, a polycarbonate resin, a polyamideimide resin, a polysulfone resin, a polyether sulfone resin, a polyarylate resin, a liquid crystal polymer, a wholly aromatic polyester resin other than a liquid crystal polymer, a polyether ketone resin, a polyether ether ketone ketone resin, and a polybenzimidazole resin.

Among the above, from the viewpoint of producing a molded article having excellent machining processability and microfabricability, the component (A) is preferably at least one selected from the group consisting of a polyimide resin, a polyetherimide resin, a polyetherimide sulfone resin, a polyphenylene sulfide resin, a polyether ether ketone resin, a polyether ketone ketone resin, a liquid crystal polymer, and a wholly aromatic polyester resin other than a liquid crystal polymer, and more preferably at least one selected from the group consisting of a polyimide resin, a polyetherimide resin, a polyphenylene sulfide resin, and a polyether ether ketone resin. When low dielectric properties are required, the component (A) is more preferably a polyimide resin, and among those a polyimide resin having an aliphatic structure (other than wholly aromatic) or a polyimide resin having a bulky structure such as a halogen.

For the component (A), the component (a1), the component (a2), or a mixture of the component (a1) and the component (a2) can be used. From the viewpoint of improving the machining processability and microfabricability of the obtained molded article, the component (A) preferably contains the component (a1), which is a crystalline thermoplastic resin.

The content of the component (a1) in the component (A) is preferably 50% by mass or more, more preferably 60% by mass or more, further preferably 70% by mass or more, still further preferably 80% by mass or more, and still further preferably 90% by mass or more, and is 100% by mass or less, from the viewpoint of improving the machining processability and microfabricability of the obtained molded article.

When the component (A) contains the component (a1), from the viewpoint of improving the machining processability and microfabricability of the obtained molded article, the viewpoint of ease of thermoforming, and the viewpoint of obtaining low dielectric properties, the component (a1) is more preferably a polyimide resin, and is more preferably a polyimide resin (a1-1) containing a repeating structural unit represented by the following formula (1) and a repeating structural unit represented by the following formula (2), a content ratio of the repeating structural unit of formula (1) to the total of the repeating structural unit of formula (1) and the repeating structural unit of formula (2) being 20 to 70 mol%.

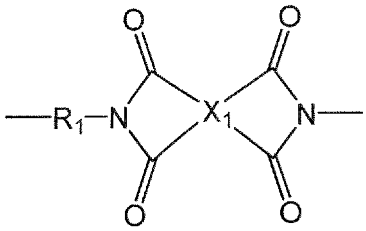

(1)

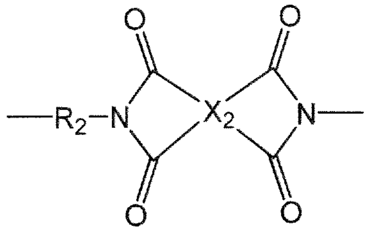

(2)

wherein $R_1$ represents a divalent group having from 6 to 22 carbon atoms containing at least one alicyclic hydrocarbon structure; $R_2$ represents a divalent chain aliphatic group having from 5 to 16 carbon atoms; and $X_1$ and $X_2$ each independently represent a tetravalent group having from 6 to 22 carbon atoms containing at least one aromatic ring.

The polyimide resin (a1-1) is a crystalline thermoplastic resin, which is preferably in a powder or pellet form. The polyimide resin is distinguished from, for example, polyimide resins formed by closing the imide ring after shaping in a state of a polyimide precursor such as a polyamic acid and having no glass transition temperature (Tg), or polyimide resins that decompose at a temperature lower than the glass transition temperature.

The repeating structural unit of formula (1) will be described in detail below.

$R_1$ represents a divalent group having from 6 to 22 carbon atoms containing at least one alicyclic hydrocarbon structure. The alicyclic hydrocarbon structure herein means a ring derived from an alicyclic hydrocarbon compound, and the alicyclic hydrocarbon compound may be either saturated or unsaturated and may be either monocyclic or polycyclic.

Examples of the alicyclic hydrocarbon structure include a cycloalkane ring, such as a cyclohexane ring, a cycloalkene ring, such as cyclohexene, a bicycloalkane ring, such as a norbornane ring, and a bicycloalkene ring, such as norbornene, but the alicyclic hydrocarbon structure is not limited thereto. Among these, a cycloalkane ring is preferred, a cycloalkane ring having from 4 to 7 carbon atoms is more preferred, and a cyclohexane ring is further preferred.

$R_1$ has from 6 to 22 carbon atoms, and preferably from 8 to 17 carbon atoms.

$R_1$ contains at least one alicyclic hydrocarbon structure, and preferably from 1 to 3 alicyclic hydrocarbon structures.

$R_1$ is preferably a divalent group represented by the following formula (R1-1) or (R1-2):

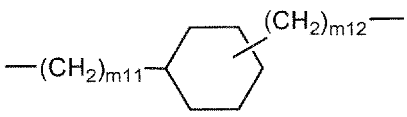

(R1-1)

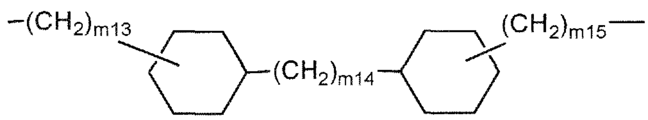

(R1-2)

wherein $m_{11}$ and $m_{12}$ each independently represent an integer of 0-2, and preferably 0 or 1; and $m_{13}$ to $m_{15}$ each independently represent an integer of 0-2, and preferably 0 or 1.

$R_1$ is particularly preferably a divalent group represented by the following formula (R1-3):

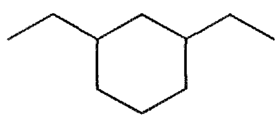

(R1-3)

In the divalent group represented by the formula (R1-3), the conformation of the two methylene groups with respect to the cyclohexane ring may be either cis or trans, and the ratio of cis and trans may be an arbitrary value.

$X_1$ is a tetravalent group having from 6 to 22 carbon atoms containing at least one aromatic ring. The aromatic ring may be either a monocyclic ring or a condensed ring, and examples thereof include a benzene ring, a naphthalene ring, an anthracene ring and a tetracene ring, but the aromatic ring is not limited thereto. Among these, a benzene ring and a naphthalene ring are preferred, and a benzene ring is more preferred.

$X_1$ has from 6 to 22 carbon atoms, and preferably has from 6 to 18 carbon atoms.

$X_1$ contains at least one aromatic ring, and preferably contains from 1 to 3 aromatic rings.

$X_1$ is preferably a tetravalent group represented by one of the following formulae (X-1) to (X-4):

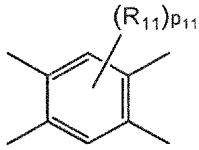

(X-1)

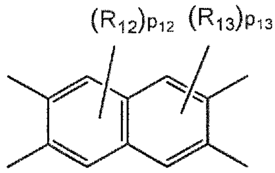

(X-2)

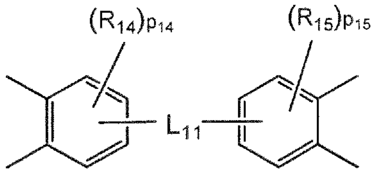

(X-3)

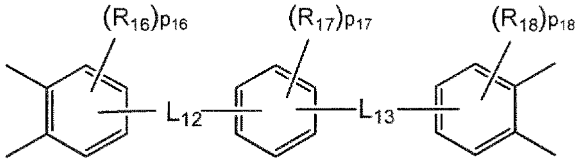

(X-4)

wherein $R_{11}$ to $R_{18}$ each independently represent an alkyl group having from 1 to 4 carbon atoms; $p_{11}$ to $p_{13}$ each independently represent an integer of 0-2, and preferably 0; $p_{14}$, $p_{15}$, $p_{16}$ and $p_{18}$ each independently represent an integer of 0-3, and preferably 0; $p_{17}$ represents an integer of 0-4, and preferably 0; and $L_{11}$ to $L_{13}$ each independently represent a single bond, an ether group, a carbonyl group or an alkylene group having from 1 to 4 carbon atoms.

$X_1$ is a tetravalent group having from 6 to 22 carbon atoms containing at least one aromatic ring, and therefore $R_{12}$, $R_{13}$, $p_{12}$ and $p_{13}$ in the formula (X-2) are selected in such a manner that the tetravalent group represented by the formula (X-2) has from 10 to 22 carbon atoms.

Similarly, $L_{11}$, $R_{14}$, $R_{15}$, $p_{14}$ and $p_{15}$ in the formula (X-3) are selected in such a manner that the tetravalent group represented by the formula (X-3) has from 12 to 22 carbon atoms, and $L_{12}$, $L_{13}$, $R_{16}$, $R_{17}$, $R_{18}$, $p_{16}$, $p_{17}$ and $p_{18}$ in the formula (X-4) are selected in such a manner that the tetravalent group represented by the formula (X-4) has from 18 to 22 carbon atoms.

$X_1$ is particularly preferably a tetravalent group represented by the following formula (X-5) or (X-6):

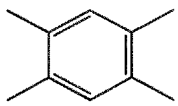

(X-5)

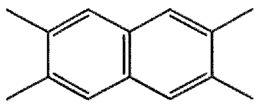

(X-6)

.

Next, the repeating structural unit of formula (2) will be described in detail below.

$R_2$ represents a divalent chain aliphatic group having from 5 to 16 carbon atoms, preferably from 6 to 14 carbon atoms, more preferably from 7 to 12 carbon atoms, and further preferably from 8 to 10 carbon atoms. The chain aliphatic group herein means a group derived from a chain aliphatic compound, and the chain aliphatic compound may be either saturated or unsaturated, may be in the form of either linear or branched chain, and may contain a hetero atom, such as an oxygen atom.

$R_2$ is preferably an alkylene group having from 5 to 16 carbon atoms, more preferably an alkylene group having from 6 to 14 carbon atoms, further preferably an alkylene group having from 7 to 12 carbon atoms, and particularly preferably an alkylene group having from 8 to 10 carbon atoms. The alkylene group may be either a linear alkylene group or a branched alkylene group, and is preferably a linear alkylene group.

$R_2$ preferably represents at least one selected from the group consisting of an octamethylene group and a decamethylene group, and particularly preferably represents an octamethylene group.

Another preferred embodiment of $R_2$ is a divalent chain aliphatic group having from 5 to 16 carbon atoms containing an ether group. The divalent chain aliphatic group preferably has from 6 to 14 carbon atoms, more preferably from 7 to 12 carbon atoms, and further preferably from 8 to 10 carbon atoms. Preferred examples of the group include a divalent group represented by the following formula (R2-1) or (R2-2):

$$-(CH_2)_{m21}-O-(CH_2)_{m22}- \qquad -(CH_2)_{m23}-O-(CH_2)_{m24}-O-(CH_2)_{m25}-$$

(R2-1) (R2-2)

wherein $m_{21}$ and $m_{22}$ each independently represent an integer of 1-15, preferably 1-13, more preferably 1-11, and further preferably 1-9; and $m_{23}$ to $m_{25}$ each independently represent an integer of 1-14, preferably 1-12, more preferably 1-10, and further preferably 1-8.

$R_2$ represents a divalent chain aliphatic group having from 5 to 16 carbon atoms (preferably from 6 to 14 carbon atoms, more preferably from 7 to 12 carbon atoms, and further preferably from 8 to 10 carbon atoms), and therefore $m_{21}$ and $m_{22}$ in the formula (R2-1) are selected so that the divalent group represented by the formula (R2-1) has from 5 to 16 carbon atoms (preferably from 6 to 14 carbon atoms, more preferably from 7 to 12 carbon atoms, and further preferably from 8 to 10 carbon atoms), i.e., $m_{21} + m_{22}$ is from 5 to 16 (preferably 6 to 14, more preferably 7 to 12, and further preferably 8 to 10).

Similarly, $m_{23}$ to $m_{25}$ in the formula (R2-2) are selected so that the divalent group represented by the formula (R2-2) has from 5 to 16 carbon atoms (preferably from 6 to 14 carbon atoms, more preferably from 7 to 12 carbon atoms, and further preferably from 8 to 10 carbon atoms), i.e., $m_{23} + m_{24} + m_{25}$ is from 5 to 16 (preferably from 6 to 14 carbon atoms, more preferably from 7 to 12 carbon atoms, and further preferably from 8 to 10 carbon atoms).

$X_2$ is defined similarly to $X_1$ in the formula (1), and preferred embodiments thereof are also the same.

The content ratio of the repeating structural unit of the formula (1) with respect to the total of the repeating structural unit of the formula (1) and the repeating structural unit of the formula (2) is 20 mol% to 70 mol%. In the case where the content ratio of the repeating structural unit of formula (1) is in the above range, the polyimide resin (a1-1) may also be sufficiently crystallized in an ordinary injection molding cycle. When the content ratio is less than 20 mol%, thermoformability deteriorates, and when the content ratio is more than 70 mol%, crystallinity deteriorates, resulting in a deterioration in heat resistance.

The content ratio of the repeating structural unit of the formula (1) with respect to the total of the repeating structural unit of the formula (1) and the repeating structural unit of the formula (2) is preferably 65 mol% or less, more preferably 60 mol% or less, and further preferably 50 mol% or less from the viewpoint of exerting high crystallinity.

Among these, the content ratio of the repeating structural unit of the formula (1) with respect to the total of the repeating structural unit of the formula (1) and the repeating structural unit of the formula (2) is preferably 20 mol% or more and less than 40 mol%. When the ratio falls within this range, the crystallinity of the polyimide resin (a1-1) increases, and it is possible to obtain a resin composition being more excellent in heat resistance.

The content ratio described above is preferably 25 mol% or more, more preferably 30 mol% or more, further preferably 32 mol% or more from the viewpoint of thermoformability, and is further preferably 35 mol% or less from the viewpoint of exerting high crystallinity.

The content ratio of the total of the repeating structural unit of the formula (1) and the repeating structural unit of the formula (2) with respect to the total repeating structural units constituting the polyimide resin (al-1) is preferably 50 to 100 mol%, more preferably 75 to 100 mol%, further preferably 80 to 100 mol%, and still further preferably 85 to 100 mol%.

The polyimide resin (a1-1) may further contain a repeating structural unit represented by the following formula (3). In this case, the content ratio of the repeating structural unit of formula (3) with respect to the total of the repeating structural unit of formula (1) and the repeating structural unit of formula (2) is preferably 25 mol% or less. The lower limit thereof is not particularly limited but needs to exceed 0 mol%.

The content ratio is preferably 5 mol% or more, and more preferably 10 mol% or more, from the viewpoint of enhancement of the heat resistance, and is preferably 20 mol% or less, and more preferably 15 mol% or less, from the viewpoint of maintenance of the crystallinity.

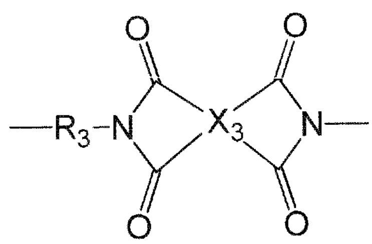

(3)

wherein $R_3$ represents a divalent group having from 6 to 22 carbon atoms containing at least one aromatic ring; and $X_3$ represents a tetravalent group having from 6 to 22 carbon atoms containing at least one aromatic ring.

$R_3$ is a divalent group having from 6 to 22 carbon atoms containing at least one aromatic ring. The aromatic ring may be either a monocyclic ring or a condensed ring, and examples thereof include a benzene ring, a naphthalene ring, an anthracene ring and a tetracene ring, but the aromatic ring is not limited thereto. Among these, a benzene ring and a naphthalene ring are preferred, and a benzene ring is more preferred.

$R_3$ has from 6 to 22 carbon atoms, and preferably has from 6 to 18 carbon atoms.

$R_3$ contains at least one aromatic ring, and preferably contains from 1 to 3 aromatic rings.

The aromatic ring may also be bonded to a monovalent or divalent electron-attracting group. Examples of the monovalent electron-attracting group include a nitro group, a cyano group, a p-toluenesulfonyl group, halogen, an alkyl halide group, a phenyl group, and an acyl group. Examples of the divalent electron-attracting group include alkylene halide groups such as alkylene fluoride groups (e.g., $-C(CF_3)_2-$ and $-(CF_2)_p-$ (wherein p is an integer of 1-10)), as well as -CO-, $-SO_2-$, -SO-, -CONH-, and -COO-.

$R_3$ is preferably a divalent group represented by the following formula (R3-1) or (R3-2):

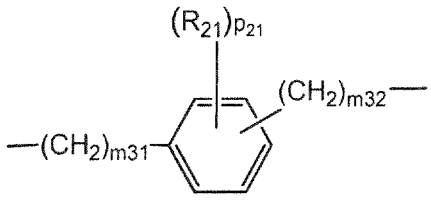

(R3-1)

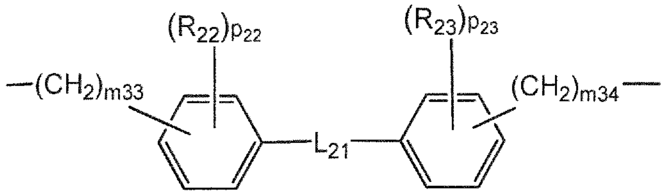

(R3-2)

wherein $m_{31}$ and $m_{32}$ each independently represent an integer of 0-2, and preferably 0 or 1; $m_{33}$ and $m_{34}$ each independently represent an integer of 0-2, and preferably 0 or 1; $R_{21}$, $R_{22}$ and $R_{23}$ each independently represent an alkyl group having from 1 to 4 carbon atoms, an alkenyl group having from 2 to 4 carbon atoms or an alkynyl group having from 2 to 4 carbon atoms; $p_{21}$, $p_{22}$ and $p_{23}$ each represent an integer of 0-4, and preferably 0; and $L_{21}$ represents a single bond, an ether group, a carbonyl group or an alkylene group having from 1 to 4 carbon atoms.

$R_3$ is a divalent group having from 6 to 22 carbon atoms containing at least one aromatic ring, and therefore $m_{31}$, $m_{32}$, $R_{21}$ and $p_{21}$ in the formula (R3-1) are selected in such a manner that the divalent group represented by the formula (R3-1) has from 6 to 22 carbon atoms.

Similarly, $L_{21}$, $m_{33}$, $m_{34}$, $R_{22}$, $R_{23}$, $p_{22}$ and $p_{23}$ in the formula (R3-2) are selected in such a manner that the divalent group represented by the formula (R3-2) has from 12 to 22 carbon atoms.

$X_3$ is defined similarly to $X_1$ in the formula (1), and preferred embodiments thereof are also the same.

The polyimide resin (al-1) may further contain a repeating structural unit represented by the following formula (4):

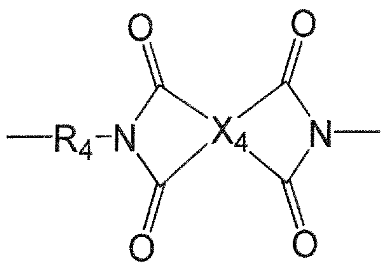

(4)

wherein $R_4$ represents a divalent group containing $-SO_2-$ or $-Si(R_x)(R_y)O-$; $R_x$ and $R_y$ each independently represent a chain aliphatic group having from 1 to 3 carbon atoms, or a phenyl group; and $X_4$ represents a tetravalent group having from 6 to 22 carbon atoms containing at least one aromatic ring.

$X_4$ is defined similarly to $X_1$ in the formula (1), and preferred embodiments thereof are also the same.

The end structure of the polyimide resin (a1-1) is not particularly limited, and preferably has a chain aliphatic group having 5 to 14 carbon atoms at the end thereof.

The chain aliphatic group may be either saturated or unsaturated, and may be in the form of either linear or branched chain. When the polyimide resin (a1-1) contains the above particular group at the end thereof, it is possible to

obtain a resin composition excellent in heat aging resistance.

Example of the saturated chain aliphatic group having from 5 to 14 carbon atoms include an n-pentyl group, an n-hexyl group, an n-heptyl group, an n-octyl group, an n-nonyl group, an n-decyl group, an n-undecyl group, a lauryl group, an n-tridecyl group, an n-tetradecyl group, an isopentyl group, a neopentyl group, a 2-methylpentyl group, a 2-methylhexyl group, a 2-ethylpentyl group, a 3-ethylpentyl group, an isooctyl group, a 2-ethylhexyl group, a 3-ethylhexyl group, an isononyl group, a 2-ethyloctyl group, an isodecyl group, an isododecyl group, an isotridecyl group and an isotetradecyl group.

Example of the unsaturated chain aliphatic group having from 5 to 14 carbon atoms include a 1-pentenyl group, a 2-pentenyl group, a 1-hexenyl group, a 2-hexenyl group, a 1-heptenyl group, a 2-heptenyl group, a 1-octenyl group, a 2-octenyl group, a nonenyl group, a decenyl group, a dodecenyl group, a tridecenyl group and a tetradecenyl group.

Among these, the chain aliphatic group is preferably a saturated chain aliphatic group, and more preferably a saturated linear aliphatic group. The chain aliphatic group preferably has 6 or more carbon atoms, more preferably 7 or more carbon atoms and further preferably 8 or more carbon atoms, and preferably has 12 or less carbon atoms, more preferably 10 or less carbon atoms and further preferably 9 or less carbon atoms from the viewpoint of achievement of heat aging resistance. The chain aliphatic group may be adopted singly or in combinations of two or more.

The chain aliphatic group is particularly preferably at least one selected from the group consisting of an n-octyl group, an isooctyl group, a 2-ethylhexyl group, an n-nonyl group, an isononyl group, an n-decyl group and an isodecyl group, further preferably at least one selected from the group consisting of an n-octyl group, an isooctyl group, a 2-ethylhexyl group, an n-nonyl group, and an isononyl group, and most preferably at least one selected from the group consisting of an n-octyl group, an isooctyl group, and a 2-ethylhexyl group.

The polyimide resin (a1-1) preferably contains only a chain aliphatic group having from 5 to 14 carbon atoms, besides a terminal amino group and a terminal carboxy group, at the end thereof from the viewpoint of heat aging resistance. When a group, besides the above groups, is contained at the end, the content thereof with respect to the chain aliphatic group having from 5 to 14 carbon atoms is preferably 10 mol% or less and more preferably 5 mol% or less.

The content of the chain aliphatic group having from 5 to 14 carbon atoms in the polyimide resin (al-1) is preferably 0.01 mol% or more, more preferably 0.1 mol% or more, and further preferably 0.2 mol% or more based on the total 100 mol% of the total repeating structural units constituting the polyimide resin (a1-1) from the viewpoint of exerting excellent heat aging resistance. In order that a sufficient molecular weight is ensured and good mechanical properties are achieved, the content of the chain aliphatic group having from 5 to 14 carbon atoms in the polyimide resin (a1-1) is preferably 10 mol% or less, more preferably 6 mol% or less and further preferably 3.5 mol% or less based on the total 100 mol% of the total repeating structural units constituting the polyimide resin (a1-1).

The content of the chain aliphatic group having from 5 to 14 carbon atoms in the polyimide resin (a1-1) can be determined by depolymerization of the polyimide resin (a1-1).

The polyimide resin (al-1) preferably has a melting point of 360°C or less and a glass transition temperature of 150°C or more. The melting point of the polyimide resin is more preferably 280°C or more and further preferably 290°C or more from the viewpoint of heat resistance, and is preferably 345°C or less, more preferably 340°C or less, and further preferably 335°C or less from the viewpoint of exerting high molding processability. In addition, the glass transition temperature of the polyimide resin (a1-1) is more preferably 160°C or more and more preferably 170°C or more from the viewpoint of heat resistance, and is preferably 250°C or less, more preferably 230°C or less, and further preferably 200°C or less from the viewpoint of exerting high molding processability.

Both the melting point and the glass transition temperature of the polyimide resin (a1-1) can be measured by a differential scanning calorimeter.

In addition, in the polyimide resin (a1-1), the exothermic amount (hereinafter, also simply referred to as "exothermic amount of crystallization") of the crystallization exothermic peak observed in melting and then cooling of the polyimide resin at a cooling rate of 20°C/min with differential scanning calorimetric measurement is preferably 5.0 mJ/mg or more, more preferably 10.0 mJ/mg or more, and further preferably 17.0 mJ/mg or more from the viewpoint of enhancement of crystallinity, heat resistance, mechanical strength, and chemical resistance. The upper limit of the exothermic amount of crystallization is not particularly limited, and is usually 45.0 mJ/mg or less.

Specifically, the melting point, the glass transition temperature, and the exothermic amount of crystallization of the polyimide resin (a1-1) can be measured by the methods described in Examples.

The logarithmic viscosity of the polyimide resin (a1-1) at 30°C in a 0.5 mass% concentrated sulfuric acid solution is preferably 0.2 to 2.0 dL/g and more preferably 0.3 to 1.8 dL/g. When the logarithmic viscosity is 0.2 dL/g or more, a molded article formed of the polyimide resin composition obtained has sufficient mechanical strength, and when the logarithmic viscosity is 2.0 dL/g or less, molding processability and handleability are good. The logarithmic viscosity $\mu$ is obtained according to the following expression by measuring the elapsed times for flowing concentrated sulfuric acid and the polyimide resin solution at 30°C with a Cannon-Fenske viscometer.

$$\mu = \ln(ts/t_0)/C$$

$t_0$: elapsed time for flowing concentrated sulfuric acid
ts: elapsed time for flowing polyimide resin solution
C: 0.5 (g/dL)

The weight average molecular weight Mw of the polyimide resin (A) is preferably in the range of 10,000 to 150,000, more preferably 15,000 to 100,000, further preferably 20,000 to 80,000, still further preferably 30,000 to 70,000, and still further preferably 35,000 to 65,000. When the weight average molecular weight Mw of the polyimide resin (a1-1) is 10,000 or more, the mechanical strength of the molded article is good, and when it is 40,000 or more, the stability of the mechanical strength is good. When the weight average molecular weight Mw is 150,000 or less, thermoformability is good.
The weight average molecular weight Mw of the polyimide resin (a1-1) can be measured by a gel permeation chromatography (GPC) method using polymethyl methacrylate (PMMA) as a standard sample.

(Method for producing polyimide resin (a1-1))

The polyimide resin (a1-1) may be produced by reacting a tetracarboxylic acid component and a diamine component. The tetracarboxylic acid component contains a tetracarboxylic acid containing at least one aromatic ring and/or a derivative thereof, and the diamine component contains a diamine containing at least one alicyclic hydrocarbon structure and a chain aliphatic diamine.
The tetracarboxylic acid containing at least one aromatic ring is preferably a compound having four carboxy groups that are bonded directly to the aromatic ring, and may contain an alkyl group in the structure thereof. The tetracarboxylic acid preferably has from 6 to 26 carbon atoms. Preferred examples of the tetracarboxylic acid include pyromellitic acid, 2,3,5,6-toluenetetracarboxylic acid, 3,3',4,4'-benzophenonetetracarboxylic acid, 3,3',4,4'-biphenyltetracarboxylic acid and 1,4,5,8-naphthalenetetracarboxylic acid. Among these, pyromellitic acid is more preferred.
Examples of the derivative of the tetracarboxylic acid containing at least one aromatic ring include an anhydride and an alkyl ester compound of a tetracarboxylic acid containing at least one aromatic ring. The derivative of the tetracarboxylic acid preferably has from 6 to 38 carbon atoms. Examples of the anhydride of the tetracarboxylic acid include pyromellitic monoanhydride, pyromellitic dianhydride, 2,3,5,6-toluenetetracarboxylic dianhydride, 3,3',4,4'-diphenylsulfonetetracarboxylic dianhydride, 3,3',4,4'-benzophenonetetracarboxylic dianhydride, 3,3',4,4'-biphenyltetracarboxylic dianhydride and 1,4,5,8-naphthalenetetracarboxylic dianhydride. Examples of the alkyl ester compound of the tetracarboxylic acid include dimethyl pyromellitate, diethyl pyromellitate, dipropyl pyromellitate, diisopropyl pyromellitate, dimethyl 2,3,5,6-toluenetetracarboxylate, dimethyl 3,3',4,4'-diphenylsulfonetetracarboxylate, dimethyl 3,3',4,4'-benzophenonetetracarboxylate, dimethyl 3,3',4,4'-biphenyltetracarboxylate and dimethyl 1,4,5,8-naphthalenetetracarboxylate. The alkyl group in the alkyl ester compound of the tetracarboxylic acid preferably has from 1 to 3 carbon atoms.
The tetracarboxylic acid containing at least one aromatic ring and/or the derivative thereof may be used as a sole compound selected from the aforementioned compounds or may be used as a combination of two or more compounds.
The diamine containing at least one alicyclic hydrocarbon structure preferably has from 6 to 22 carbon atoms, and preferred examples thereof include 1,2-bis(aminomethyl)cyclohexane, 1,3-bis(aminomethyl)cyclohexane, 1,4-bis(aminomethyl)cyclohexane, 1,2-cyclohexanediamine, 1,3-cyclohexanediamine, 1,4-cyclohexanediamine, 4,4'-diaminodicyclohexylmethane, 4,4'-methylenebis(2-methylcyclohexylamine), carvone diamine, limonene diamine, isophorone diamine, norbornane diamine, bis(aminomethyl)tricyclo[5.2.1.0$^{2,6}$]decane, 3,3'-dimethyl-4,4'-diaminodicyclohexylmethane and 4,4'-diaminodicyclohexylpropane. These compounds may be used solely or may be used as a combination of two or more compounds selected therefrom. Among these, 1,3-bis(aminomethyl)cyclohexane is preferably used. A diamine containing an alicyclic hydrocarbon structure generally has conformational isomers, and the ratio of the cis isomer and the trans isomer is not particularly limited.
The chain aliphatic diamine may be in the form of either linear or branched chain, and has preferably from 5 to 16 carbon atoms, more preferably from 6 to 14 carbon atoms and further preferably from 7 to 12 carbon atoms. The linear moiety having from 5 to 16 carbon atoms may contain an ether bond in the course thereof. Preferred examples of the chain aliphatic diamine include 1,5-pentamethylenediamine, 2-methylpentane-1,5-diamine, 3-methylpentane-1,5-diamine, 1,6-hexamethylenediamine, 1,7-heptamethylenediamine, 1,8-octamethylenediamine, 1,9-nonamethylenediamine, 1,10-decamethylenediamine, 1,11-undecamethylenediamine, 1,12-dodecamethylenediamine, 1,13-tridecamethylenediamine, 1,14-tetradecamethylenediamine, 1,16-hexadecamethylenediamine, and 2,2'-(ethylenedioxy)bis(ethyleneamine).
The chain aliphatic diamine may be used as a sole compound or as a mixture of plural kinds thereof. Among these, a chain aliphatic diamine having from 8 to 10 carbon atoms can be preferably used, and at least one selected from the group consisting of 1,8-octamethylenediamine and 1,10-decamethylenediamine can be particularly preferably used.

In the production of the polyimide resin (a1-1), the molar ratio of the charged amount of the diamine containing at least one alicyclic hydrocarbon structure with respect to the total amount of the diamine containing at least one alicyclic hydrocarbon structure and the chain aliphatic diamine is preferably 20 to 70 mol%. The molar ratio is preferably 25 mol% or more, more preferably 30 mol% or more, further preferably 32 mol% or more, and is preferably 60 mol% or less, more preferably 50 mol% or less, further preferably less than 40 mol, and further preferably 35 mol% or less from the viewpoint of exerting high crystallinity.

The diamine component may contain a diamine containing at least one aromatic ring. The diamine containing at least one aromatic ring preferably has from 6 to 22 carbon atoms, and examples thereof include o-xylylenediamine, m-xylylenediamine, p-xylylenediamine, 1,2-diethynylbenzenediamine, 1,3-diethynylbenzenediamine, 1,4-diethynylbenzenediamine, 1,2-diaminobenzene, 1,3-diaminobenzene, 1,4-diaminobenzene, 4,4'-diaminodiphenyl ether, 3,4'-diaminodiphenyl ether, 4,4'-diaminodiphenylmethane, $\alpha,\alpha'$-bis(4-aminophenyl)-1,4-diisopropylbenzene, $\alpha,\alpha'$-bis(3-aminophenyl)-1,4-diisopropylbenzene, 2,2-bis(4-(4-aminophenoxy)phenyl)propane, 2,6-diaminonaphthalene and 1,5-diaminonaphthalene.

The molar ratio of the charged amount of the diamine containing at least one aromatic ring with respect to the total amount of the diamine containing at least one alicyclic hydrocarbon structure and the chain aliphatic diamine is preferably 25 mol% or less. The lower limit thereof is not particularly limited but needs to exceed 0 mol%.

The molar ratio is preferably 5 mol% or more, and more preferably 10 mol% or more, from the viewpoint of enhancement of the heat resistance, and is preferably 20 mol% or less, and more preferably 15 mol% or less, from the viewpoint of maintenance of the crystallinity.

In addition, the molar ratio is preferably 12 mol% or less, more preferably 10 mol% or less, further preferably 5 mol% or less and still more preferably 0 mol% from the viewpoint of a decrease in coloration of the polyimide resin.

In the production of the polyimide resin (a1-1), the charged amount ratio of the tetracarboxylic acid component and the diamine component is preferably from 0.9 to 1.1 mol of the diamine component per 1 mol of the tetracarboxylic acid component.

In the production of the polyimide resin (a1-1), an end capping agent may be mixed in addition to the tetracarboxylic acid component and the diamine component. The end capping agent is preferably at least one selected from the group consisting of a monoamine compound and a dicarboxylic acid compound. The amount of the end capping agent to be used may be any amount as long as a desired amount of an end group can be introduced into the polyimide resin (a1-1), and the amount is preferably 0.0001 to 0.1 mol, more preferably 0.001 to 0.06 mol, and further preferably 0.002 to 0.035 mol, per 1 mol of the tetracarboxylic acid and/or the derivative thereof.

Among them, monoamine end capping agents are preferable as the end capping agent, and from the viewpoint of introducing the above-described chain aliphatic group having 5 to 14 carbon atoms at an end of the polyimide resin (a1-1) to improve heat aging resistance, a monoamine that has a chain aliphatic group having 5 to 14 carbon atoms is more preferable, and a monoamine that has a saturated linear aliphatic group having 5 to 14 carbon atoms is further preferable.

The end capping agent is particularly preferably at least one selected from the group consisting of n-octylamine, isooctylamine, 2-ethylhexylamine, n-nonylamine, isononylamine, n-decylamine, and isodecylamine, further preferably at least one selected from the group consisting of n-octylamine, isooctylamine, 2-ethylhexylamine, n-nonylamine, and isononylamine, and most preferably at least one selected from the group consisting of n-octylamine, isooctylamine, and 2-ethylhexylamine.

As a polymerization method for producing the polyimide resin (a1-1), a known polymerization method may be applied, and the method described in WO 2016/147996 can be used.

The content of the polyimide resin (a1-1) in the component (A) is, from the viewpoint of improving the machining processability and microfabricability of the obtained molded article, the viewpoint of ease of thermoforming, and the viewpoint of obtaining low dielectric properties, preferably 30% by mass or more, more preferably 50% by mass or more, further preferably 60% by mass or more, still further preferably 70% by mass or more, still further preferably 80% by mass or more, and still further preferably 90% by mass or more, and is 100% by mass or less.

The content of the component (A) in the thermoplastic resin composition is preferably 40% by mass or more, more preferably 50% by mass or more, further preferably 60% by mass or more, still further preferably 65% by mass or more, and still further preferably 70% by mass or more, from the viewpoint of improving the machining processability and microfabricability of the obtained molded article. Further, the content is preferably 95% by mass or less, more preferably 90% by mass or less, further preferably 85% by mass or less, and still further preferably 80% by mass or less, from the viewpoint of improving the machining processability and microfabricability of the obtained molded article.

<Component (B): inorganic filler including zirconium oxide (b1)>

The thermoplastic resin composition of the present invention contains an inorganic filler including zirconium oxide (b1) as the component (B).

By using the thermoplastic resin (A) and the inorganic filler (B) including a predetermined amount of zirconium

oxide (b1), a molded article having excellent machining processability and microfabricability can be produced.

(Component (b1): zirconium oxide)

The shape of the zirconium oxide (b1) used in the present invention is not particularly limited, and examples include spherical, plate-like, scale-like, columnar, and fibrous. Among these, spherical or plate-shaped particles are preferable, and spherical particles are more preferable, from the viewpoint of improving the machining processability and microfabricability of the obtained molded article.

The zirconium oxide (b1) preferably has a small particle size from the viewpoint of improving the machining processability and microfabricability of the obtained molded article and from the viewpoint of availability. For example, from the viewpoint of improving the machining processability and microfabricability of the obtained molded article, the component (b1) has a volume median diameter (D50) of preferably 1 μm or less, more preferably 0.80 μm or less, further preferably 0.60 μm or less, still further preferably 0.50 μm or less, and still further preferably 0.40 μm or less. Further, from the viewpoint of improving the machining processability and microfabricability of the obtained molded article, availability, and the viewpoint of improving handleability, the volume median diameter (D50) is usually 0.01 μm or more, more preferably 0.02 μm or more, and further preferably 0.05 μm or more.

The D50 of the component (b1) can be measured using a laser diffraction light scattering particle size distribution measuring instrument.

Examples of commercially available zirconium oxide particles used as the component (b1) include the KZ series manufactured by KCM Corporation, the TZ series manufactured by Tosoh Corporation, the UEP series manufactured by Daiichi Kigenso-Kagaku Kogyo Co., Ltd., and the like. Among these, the KZ series high purity zirconia "KZ-0Y-LSF" manufactured by KCM Corporation can be suitably selected.

The content of the component (b1) in component (B) is, preferably 20% by mass or more, more preferably 30% by mass or more, further preferably 35% by mass or more, still further preferably 40% by mass or more, still further preferably 50% by mass or more, and still further preferably 60% by mass or more, and is 100% by mass or less, preferably 90% by mass or less, more preferably 80% by mass or less, and further preferably 70% by mass or less, from the viewpoint of improving the machining processability and microfabricability of the obtained molded article.

The content of the component (b1) with respect to 100 parts by mass of the component (A) in the thermoplastic resin composition is 2 to 40 parts by mass, preferably 5 to 35 parts by mass, more preferably 5 to 30 parts by mass, further preferably 10 to 30 parts by mass, and still further preferably 20 to 30 parts by mass, from the viewpoint of thermoformability and the viewpoint of improving the machining processability and microfabricability of the obtained molded article.

(Component (b2): inorganic filler other than component (bl))

The component (B) may be an inorganic filler composed only of the component (b1), or may further include an inorganic filler (b2) other than the component (b1).

Examples of the component (b2) include talc, mica, silica, alumina, wollastonite, silicon nitride, aluminum nitride, boron nitride, silicon carbide, boron carbide, calcium carbonate, titanium oxide, zinc oxide, calcium oxide, magnesium carbonate, barium carbonate, magnesium sulfate, barium sulfate, antimony trisulfide, tin sulfide, copper sulfide, iron sulfide, bismuth sulfide, and zinc sulfide. One or more of these can be used.

Among the above, from the viewpoint of improving the machining processability and microfabricability of the obtained molded article, the component (b2) is preferably at least one selected from the group consisting of talc, mica, silica, alumina, silicon nitride, aluminum nitride, boron nitride, silicon carbide, boron carbide, calcium carbonate, and titanium oxide, more preferably at least one selected from the group consisting of talc, mica, silica, and titanium oxide, further preferably at least one selected from the group consisting of talc and silica, and still further preferably is talc. In cases where it is desired to further improve the low dielectric properties, it is preferable to use a hollow inorganic filler such as hollow silica or hollow alumina.

The shape of the component (b2) used is also not particularly limited, and examples include spherical, plate-like, scale-like, columnar, and fibrous. Among these, from the viewpoint of improving the machining processability and microfabricability of the obtained molded article, and the viewpoint of availability, spherical or plate-shaped particles are preferable.

From the viewpoint of improving the machining processability and microfabricability of the obtained molded article and from the viewpoint of availability, the component (b2) has a volume median diameter (D50) of preferably 3 μm or less, more preferably 2 μm or less, further preferably 1.5 μm or less, still further preferably 1.2 μm or less, and still further preferably 1 μm or less. Further, from the viewpoint of improving the machining processability and microfabricability of the obtained molded article, availability, and the viewpoint of improving handleability, the volume median diameter (D50) is usually 0.01 μm or more, more preferably 0.05 μm or more, and further preferably 0.1 μm or more.

The D50 of the component (b2) can be measured by the same method as for the component (b1).

When the component (b2) is used, the content of the component (b2) in the component (B) is, from the viewpoint of thermoformability and the viewpoint of improving the machining processability and microfabricability of the obtained molded article, preferably 80% by mass or less, more preferably 70% by mass or less, further preferably 65% by mass or less, still further preferably 60% by mass or less, still further preferably 50% by mass or less, and still further preferably 40% by mass or less, and is preferably 1% by mass or more, more preferably 5% by mass or more, further preferably 10% by mass or more, still further preferably 15% by mass or more, still further preferably 20% by mass or more, and still further preferably 30% by mass or more.

When the component (b2) is used, the content of the component (b2) with respect to 100 parts by mass of the component (A) in the thermoplastic resin composition is, preferably 1 to 40 parts by mass, more preferably 2 to 30 parts by mass, further preferably 5 to 30 parts by mass, and still further preferably 10 to 20 parts by mass, from the viewpoint of improving the machining processability and microfabricability of the obtained molded article.

The content of the component (B) with respect to 100 parts by mass of the component (A) in the thermoplastic resin composition is, 2 to 60 parts by mass, preferably 5 to 50 parts by mass, more preferably 10 to 45 parts by mass, further preferably 15 to 45 parts by mass, still further preferably 20 to 45 parts by mass, still further preferably 25 to 45 parts by mass, and still further preferably 30 to 45 parts by mass, from the viewpoint of thermoformability and the viewpoint of improving the machining processability and microfabricability of the obtained molded article.

<Additive>

In the thermoplastic resin composition of the present invention, an additive other than the component (B) may be optionally added, such as a reinforcement fiber, a delusterant, a plasticizer, an antistatic agent, an anti-coloring agent, an anti-gelling agent, a colorant, a slidability-improving agent, an antioxidant, a conducting agent, and a resin-modifying agent. In particular, by using graphite, carbon black, graphite, Ketjenblack, or carbon nanotubes as an antistatic agent, a sufficient antistatic effect can be expressed even when added in a small amount that does not impair the properties of the thermoplastic resin composition of the present invention, and thus such an antistatic agent can be suitably used.

In the case of using an above-described additive, the added amount of the additive is not particularly limited, and is usually 50% by mass or less, preferably 0.0001 to 30% by mass, more preferably 0.001 to 15% by mass, and further preferably 0.01 to 10% by mass, from the viewpoint of exerting the effect of the additive.

Further, a resin other than the thermoplastic resin (A) can be mixed into the thermoplastic resin composition of the present invention as long as the characteristics of the thermoplastic resin composition are not impaired. When the thermoplastic resin (A) is used in combination with the resin other than the thermoplastic resin (A), the rate of such another resin to be mixed is not particularly limited, as long as the characteristics of the thermoplastic resin composition are not impaired.

However, the total content of the component (A) and the component (B) in the thermoplastic resin composition of the present invention is preferably 30% by mass or more, more preferably 40% by mass or more, further preferably 50% by mass or more, still further preferably 70% by mass or more, still further preferably 80% by mass or more, and still further preferably 90% by mass or more, and is 100% by mass or less, from the viewpoint of obtaining the effects of the present invention.

Although the thermoplastic resin composition of the present invention can take any form, it is preferably a pellet.

The thermoplastic resin composition of the present invention can be obtained as pellets by, for example, adding the thermoplastic resin (A), the inorganic filler (B), and various optional components as necessary into an extruder and dry-blending those components to obtain a mixture, or feeding the inorganic filler (B) and the optional components separately from the location where the thermoplastic resin (A) is fed into the extruder, then melt-kneading the mixture in the extruder, extruding a strand, and cutting the strand into pellets. Further, a molded article having a desired shape can be easily produced by introducing the obtained pellets into various molding machines and thermoforming by the method described later. On the other hand, it is also possible to obtain a molded article without going through the pellet form. For example, the thermoplastic resin (A), the inorganic filler (B), and the various optional components as necessary may be added, the resultant mixture dry blended, then the dry-blended mixture charged into a mold, and compression molded by hot pressing to obtain the molded article directly.

The thermoplastic resin composition of the present invention preferably does not contain a solvent from the viewpoint of forming into pellets and the viewpoint of performing compression molding. Specifically, a solvent content in the thermoplastic resin composition is preferably 5% by mass or less, more preferably 1% by mass or less, and further preferably 0.1% by mass or less.

[Molded article]

The present invention provides a molded article including the above-described thermoplastic resin composition.

The molded article of the present invention can be produced by thermoforming the thermoplastic resin

composition. Examples of the thermoforming method include injection molding, extrusion molding, inflation molding, blow molding, heat press molding (compression molding), vacuum molding, pressure forming, laser molding, welding, heat adhesion, and the like, and the thermoplastic resin composition of the present invention may be molded by any molding method that includes a heat melting step. Injection molding or extrusion molding is preferable from the viewpoint of performing thermoforming using the above-described pellets and machining the obtained molded article. In particular, injection molding is preferred from the viewpoint of production efficiency, and extrusion molding is preferred from the viewpoint of higher dimensional stability.

The method for producing a molded article depends on the melting point or glass transition temperature of the thermoplastic resin (A), but when the thermoplastic resin (A) contains the polyimide resin (al-1), it is preferred to include a step of thermoforming the thermoplastic resin composition at 290 to 380°C. Thermoforming at a temperature above 380°C to 400°C is also possible, but from the viewpoint of suppressing deterioration of the thermoplastic resin (A) and other components, it is preferable to perform the thermoforming at a temperature of 380°C or less. Examples of the specific procedure include the following methods.

First, the thermoplastic resin (A) is dry blended with the inorganic filler (B) and various optional components as necessary, then introduced into an extruder, melted at preferably 290 to 380°C, and melt-kneaded in the extruder and extruded to produce pellets. Alternatively, the thermoplastic resin (A) may be introduced into the extruder, melted at preferably 290 to 380°C, the inorganic filler (B) and various optional components as necessary introduced thereto and melt-kneaded with the thermoplastic resin (A) in the extruder, and extruded to produce the pellets.

The pellets may be dried, then introduced in various kinds of molding machines, and heat-molded preferably at from 290 to 380°C, thereby producing a molded article having a desired shape.

The molded article obtained by the above-described thermoforming may be formed into a desired shape by further subjecting it to a machining process and the like. For example, an injection-molded article can be produced using the thermoplastic resin composition, and then formed into a desired shape by subjecting it to a machining process.

It is preferred to further subject the molded article obtained by the above-described thermoforming to an annealing treatment from the viewpoint of further improving machining processability and microfabricability. When a molded article obtained by further performing an annealing treatment after thermoforming the thermoplastic resin composition is subjected to a machining process, a flat plate having a low surface roughness on the machined surface and less warpage can be obtained. Further, using the flat plate, finer through holes can be formed.

The annealing treatment temperature can be set according to the type of the thermoplastic resin (A) used. When the thermoplastic resin (A) is the crystalline thermoplastic resin (a1), the annealing treatment temperature is set to be lower than the melting point of crystalline thermoplastic resin (a1) from the viewpoint of avoiding deformation of the molded article, and taking the melting point of the crystalline thermoplastic resin (a1) to be Tm (°C), the annealing treatment temperature preferably is set in the range of Tm -100°C to Tm -20°C from the viewpoint of further improving machining processability and microfabricability and the viewpoint of avoiding deformation of the molded article. When the thermoplastic resin (A) is the amorphous thermoplastic resin (a2), the annealing treatment temperature is lower than the glass transition temperature of the amorphous thermoplastic resin (a2) from the viewpoint of avoiding deformation of the molded article, and taking the glass transition temperature of the amorphous thermoplastic resin (a2) to be Tg (°C), the annealing treatment temperature preferably is set in the range of Tg -100°C to Tg -20°C from the viewpoint of further improving machining processability and microfabricability and the viewpoint avoiding deformation of the molded article.

A specific example of the annealing treatment temperature is, when the thermoplastic resin (A) contains the polyimide resin (a1-1), a temperature in the range of preferably 200 to 360°C, more preferably 220 to 340°C, further preferably 240 to 330°C, and still further preferably 250 to 320°C, from the viewpoint of further improving machining processability and microfabricability, and the viewpoint of avoiding deformation of the molded article.

The annealing treatment time is not particularly limited, but is preferably in the range of 1 to 120 minutes, and more preferably 5 to 60 minutes from the viewpoint of further improving the machining processability and microfabricability of the molded article, and the viewpoint of improving manufacturing efficiency.

The annealing treatment of the molded article can be performed using a known heating device.

After the annealing treatment, the molded article is gradually cooled to a temperature of preferably 100°C or less from the viewpoint of suppressing the occurrence of warping of the molded article due to residual stress.

[Component part of IC socket for inspection]

The present invention further provides a component part of an IC socket for inspection (hereinafter also simply referred to as "member of the present invention" or "member") obtained by processing the molded article.

As used herein, examples of the IC socket for inspection include an IC socket for inspection of a product (test socket), an IC socket for a burn-in test (burn-in socket), and the like.

The member of the present invention may be any member that constitutes at least a portion of an IC socket for inspection. Examples of the member include a roughly flat plate-like member used in a site where the device to be

inspected is mounted. The roughly flat plate-like member has fine through holes into which the device is fitted.

The member of the present invention can be produced, for example, by the following method. First, thermoforming (preferably injection-molding) is performed using the above-described thermoplastic resin composition to produce a molded article. Next, preferably after performing an annealing treatment, the molded article is subjected to a machining process using an electric drill or the like to obtain a machined plate. This machined plate is microfabricated using an electric drill, a laser, or the like to form a plurality of through holes, and a member having a desired shape is obtained.

Fig. 1 is a schematic plan view showing an embodiment of a component part 100 of an IC socket for inspection. In Fig. 1, reference numeral 10 denotes a machined plate and reference numeral 20 denotes a through hole formation area.

The machined plate 10 used for producing the member 100 preferably has a low surface roughness on the machined surface from the viewpoint of improving microfabricability. For example, the arithmetic average roughness (Ra) of the machined surface of the machined plate 10 is preferably 1 μm or less, more preferably 0.8 μm or less, further preferably 0.6 μm or less, and still further preferably 0.3 μm or less.

The arithmetic average roughness can be measured by, specifically, the method described in the examples.

In the through hole formation area 20, a plurality of through holes are regularly arranged at a narrow pitch. The diameter of the through holes is usually selected in the range of 0.01 to 0.20 mm, and the pitch in the range of 0.02 to 0.40 mm. In addition, a hole diameter of 0.1 mm or more is suitable for allowing various probes such as a wire probe or a spring probe to be used, and a hole diameter of less than 0.1 mm is suitable for allowing a wire probe having a smaller diameter to be used for more detailed inspection.

A molded article produced by injection-molding or the like using the thermoplastic resin composition of the present invention has a low surface roughness on the machined surface when subjected to a machining process, and has good machining processability. Further, when a large number of through holes are formed at a narrow pitch in the obtained machined plate using an electric drill, laser, or the like, the hole size distribution does not increase, there is little pattern collapse or occurrence of burrs, and the microfabricability is also good.

Further, as described above, since a molded article produced by injection-molding or the like using the thermoplastic resin composition of the present invention has excellent machining processability, in addition to an IC socket member, the produced molded article is also highly adaptable to applications that require a precision machining process, such as gears, bearings, and watch housings.

Examples

The present invention will be described in more detail with reference to examples below, but the present invention is not limited thereto. Further, various measurements and evaluations in each Production Example and Example were carried out in the following manner.

<Infrared spectroscopy (IR measurement)>

The IR measurement of the polyimide resin was performed with "JIR-WINSPEC 50", produced by JEOL, Ltd.

<Logarithmic viscosity μ>

The polyimide resin was dried at from 190 to 200°C for 2 hours, and then 0.100 g of the polyimide resin was dissolved in 20 mL of concentrated sulfuric acid (96%, produced by Kanto Chemical Co., Inc.) to form a polyimide resin solution, and the measurement was made at 30°C with a Cannon-Fenske viscometer using the polyimide resin solution as a measurement sample. The logarithmic viscosity μ was obtained according to the following expression.

$$\mu = \ln(ts/t_0)/C$$

$t_0$: elapsed time for flowing concentrated sulfuric acid
ts: elapsed time for flowing polyimide resin solution
C: 0.5 g/dL

<Melting point, glass transition temperature, crystallization temperature, and exothermic amount of crystallization>

The melting point Tm, glass transition temperature Tg, crystallization temperature Tc, and exothermic amount of crystallization ΔHm of the polyimide resin were measured with a differential scanning calorimeter ("DSC-6220", manufactured by SII Nanotechnology, Inc.).

The polyimide resin was subjected to the following thermal history in a nitrogen atmosphere. The condition of the thermal history included the first heating (heating rate: 10°C/min), then cooling (cooling rate: 20 °C/min), and then second heating (heating rate: 10°C/min).

The melting point Tm was determined by reading the peak top value of the endothermic peak observed in the second heating. The glass transition temperature (Tg) was determined by reading the value observed in the second heating. The crystallization temperature (Tc) was determined by reading the peak top value of the exothermic peak observed in cooling.

The exothermic amount of crystallization ΔHm (mJ/mg) was calculated from the area of the exothermic peak observed in cooling.

<Crystallization half-time>

The crystallization half-time of the polyimide resin was measured with a differential scanning calorimeter ("DSC-6220", produced by SII Nanotechnology, Inc.).

A polyimide resin having a half-crystallization time of 20 seconds or less was measured under the following conditions. That is, the polyimide resin was held at 420°C for 10 minutes in a nitrogen atmosphere so as to completely melt, then quenched at a cooling rate of 70 °C/min, and the time required from the appearance of the observed crystallization peak to the peak top thereof was calculated.

<Weight average molecular weight>

The weight average molecular weight (Mw) of the polyimide resin was measured with a gel permeation chromatography (GPC) measurement apparatus "Shodex GPC-101" produced by Showa Denko K.K. under the following conditions:

Column: Shodex HFIP-806M
Mobile phase solvent: HFIP containing 2 mM sodium trifluoroacetate
Column temperature: 40°C
Flow rate of mobile phase: 1.0 mL/min
Specimen concentration: about 0.1 mass%
Detector: IR detector
Amount of injection: 100 μm
Calibration curve: standard PMMA

Production Example 1 (Production of polyimide resin 1)

500 g of 2-(2-methoxyethoxy)ethanol (produced by Nippon Nyukazai Co., Ltd.) and 218.12 g (1.00 mol) of pyromellitic dianhydride (produced by Mitsubishi Gas Chemical Company, Inc.) were introduced in a 2 L separable flask equipped with a Dean-Stark apparatus, a Liebig condenser tube, a thermocouple, and a four-paddle blade. After creation of a nitrogen flow, the mixture was agitated at 150 rpm so as to become a homogeneous suspended solution. On the other hand, 49.79 g (0.35 mol) of 1,3-bis(aminomethyl)cyclohexane (produced by Mitsubishi Gas Chemical Company, Inc., cis/trans ratio = 7/3) and 93.77 g (0.65 mol) of 1,8-octamethylenediamine (produced by Kanto Chemical Co., Inc.) were dissolved in 250 g of 2-(2-methoxyethoxy)ethanol with a 500 mL beaker, thereby preparing a mixed diamine solution. This mixed diamine solution was added into the suspended solution gradually with a plunger pump. Heat was generated due to the drop addition, but the internal temperature was adjusted to be within the range of 40 to 80°C. The dropwise addition of the mixed diamine solution was carried out in a nitrogen flow state over the whole period. The number of rotations of the agitation blade was set to 250 rpm. After the completion of the dropwise addition, 130 g of 2-(2-methoxyethoxy)ethanol and 1.284 g (0.0010 mol) of n-octylamine (produced by Kanto Chemical Co., Inc.) as an end capping agent were added thereto, and the mixture was further agitated. At this stage, a pale yellow polyamic acid solution was obtained. Next, the agitation speed was set to 200 rpm, and the polyamic acid solution in the 2 L separable flask was then heated to 190°C. In this heating process, the deposition of a polyimide resin powder and dehydration associated with imidization were confirmed at a solution temperature of from 120 to 140°C. The solution was kept at 190°C for 30 minutes, then allowed to cool to room temperature, and filtered. The obtained polyimide resin powder was washed with 300 g of 2-(2-methoxyethoxy)ethanol and 300 g of methanol, filtered, and then dried in a dryer at 180°C for 10 hours to obtain 317 g of a powder of a polyimide resin 1, which was a crystalline thermoplastic resin.

The measurement of the IR spectrum of polyimide resin 1 showed the characteristic absorption of an imide ring ν(C=O) observed at 1768 and 1697 ($cm^{-1}$). The logarithmic viscosity was 1.30 dL/g, Tm was 323°C, Tg was 184°C, Tc was 266°C, the exothermic amount of crystallization was 21.0 mJ/mg, the crystallization half-time was 20 seconds or less, and

Mw was 55,000.

Table 1 shows the composition and evaluation results of the polyimide resin of Production Example 1. The values expressed in mol% of the tetracarboxylic acid component and the diamine component in Table 1 are values calculated from the charged amount of each component in production of the polyimide resin.

Table 1

| | | Tetracarboxylic acid component (mol% in total tetracarboxylic acid component) | Diamine component (mol% in total diamine component) | | (1)/{(1)+(2)} (mol%) *1 | Tm (°C) | Tg (°C) | Tc (°C) | Exothermic amount of crystallization ΔHm (mJ/mg) | Half-crystallization time (sec) | Mw |
|---|---|---|---|---|---|---|---|---|---|---|---|
| | | PMDA | 1,3-BAC | OMDA | | | | | | | |
| Production Example 1 | Polyimide resin 1 | 100 | 35 | 65 | 35 | 323 | 184 | 266 | 21.0 | <20 | 55,000 |

*1: Content ratio (mol%) of the repeating structural unit of the formula (1) with respect to the total of the repeating structural unit of the formula (1) and the repeating structural unit of the formula (2) in the polyimide resin

The abbreviations in the table 1 are as follows.

- PMDA; pyromellitic dianhydride
- 1,3-BAC; 1,3-bis(aminomethyl)cyclohexane
- OMDA; 1,8-octamethylenediamine

Examples 1 to 9 and Comparative Examples 1 to 6 (Production and evaluation of thermoplastic resin composition and molded article (1))

The component (A) and the component (B) shown in Table 2 were thoroughly mixed by dry blending. The obtained mixed powder was mixed with a co-rotating twin screw extruder ("HK-25D-41D", manufactured by Parker Corporation, screw diameter: 25 mm) at a barrel temperature of 360°C and a screw rotation speed of 120 rpm, and extruded in strands having a diameter of 2 to 3 mm. The discharge rate and dischargeability of the strands at this time were observed, and the production stability of the resin composition during twin-screw extrusion was evaluated according to the following criteria.

<Production stability during twin screw extrusion>

The discharge rate (kg/h) and discharability of the strands extruded from the twin-screw kneading extruder in the above method were observed, and the production stability of the resin composition during twin-screw extrusion was evaluated according to the following criteria.

AA: Discharge rate was over 4 kg/h, and the strands were uniformly discharged.
A: Discharge amount was 3 to 4 kg/h, and the strands were uniformly discharged.
B: Discharge rate was 3 to 4 kg/h, and the strands discharged, but unevenly.
C: Discharge rate was less than 3 kg/h.

The strands extruded from the extruder were air cooled, and then pelletized by a pelletizer ("Fan Cutter FC-Mini-4/N", produced by Hoshi Plastic Co., Ltd.). The obtained pellets (thermoplastic resin composition) were dried at 150°C for 10 hours, and then used for injection-molding.
Injection-molding was performed at a barrel temperature of 375°C, a mold temperature of 200°C, and a molding cycle of 60 seconds with an injection-molding machine ("ROBOSHOT $\alpha$-S30iA", produced by FANUC Corporation), and a flat plate-like injection-molded article having a thickness of 70 mm $\times$ 70 mm $\times$ 4 mm was produced. The injection-molding properties at this time were evaluated by the following method.

<Evaluation of injection-molding properties>

The injection-molding properties of the resin composition were evaluated based on the following three items.

(Apparatus load)

The torque when feeding the resin composition pelletized by the above method into the cylinder of the injection-molding machine was observed, and the apparatus load was evaluated according to the following criteria.

A: When feeding the pellets into the cylinder, there was a sufficient margin to the torque limit.
B: When feeding the pellets into the cylinder, the torque limit was nearly reached, but molding was possible.
C: When feeding the pellets into the cylinder, the torque limit was reached, and molding was not possible.

(Molded article surface roughness)

The surface of injection-molded articles obtained by the above method was visually observed, and surface roughness was evaluated according to the following criteria.

AA: No occurrence of silver streaks or air bubbles.
A: Slight occurrence of silver streaks or air bubbles.

B: Large amount of silver streaks or air bubbles were formed, although not over all of the surface.
C: Silver streaks or air bubbles observed over the entire surface and in a large amount.

(Molded article burn)

The surface of injection-molded articles obtained by performing injection-molding in 10 consecutive shots according to the above method was visually observed, and burn was evaluated according to the following criteria.

AA: No burn observed over the consecutive molding of 10 shots.
A: Burn gradually observed over the consecutive molding of 10 shots.
B: Burn visible from the first shot.
C: Burn visible from the first shot and gradually became more pronounced.

<Machining processability evaluation (1)>

The machining processability of the injection-molded articles was evaluated using the following method.

(Surface roughness during cutting)

Injection-molded articles obtained by the above method were machined to produce a flat plate measuring 50 mm × 50 mm × 3 mm thick. On the machined surface of the obtained flat plate, the arithmetic average roughness (Ra) of a continuous area of 20 mm in length was measured in the direction perpendicular to the cutting direction using a 3D shape measuring instrument ("VR-6000", manufactured by Keyence Corporation), and the surface roughness was evaluated according to the following criteria.

A: Arithmetic average roughness of 0.6 μm or less
B: Arithmetic average roughness of more than 0.6 μm and 1μm or less
C: Arithmetic average roughness of more than 1 μm

<Microfabricability evaluation (1)>

The microfabricability of the flat plate (machined plate) was evaluated based on the following two items.

(Hole size distribution of microholes (100 μm))

A total of 576 through holes, 24 × 24, were formed at a pitch of 0.12 mm on the area 20 (within an area of approximately 3 mm × 3 mm) near the center of the machined plate 10 of 50 mm × 50 mm × 3 mm thick shown in Fig. 1 using an electric drill (drill diameter: 0.10 mm). The diameter of the formed through holes was measured using a high-precision image dimension measuring instrument ("LM series", manufactured by Keyence Corporation), and evaluated based on the diameter distribution according to the following criteria.

A: Diameter of all through holes between 0.090 and 0.110 mm.
C: Some through holes have diameter exceeding the range of 0.090 to 0.110 mm.

(Microhole (100 μm) appearance and burr state)

The appearance of the through holes formed by the above method was observed with a digital microscope ("VHX-7000", manufactured by Keyence Corporation, magnification: 50 times) and evaluated according to the following criteria.

AA: No pattern collapse and few burrs.
A: Some pattern collapse and burrs.
C: Large pattern collapse and holes close together, or a large amount of burrs.

The above evaluation results are shown in Table 2. In addition, regarding Comparative Examples 2 and 5, the machining processability and microfabricability after injection-molding could not be evaluated due to poor injection-molding properties.

Table 2

| (% by mass) | | | Example | | | Comparative Example | | | | Example | | | Comparative Example | Example | | | Comparative Example |
|---|---|---|---|---|---|---|---|---|---|---|---|---|---|---|---|---|---|
| | | | 1 | 2 | 3 | 1 | 2 | 3 | 4 | 4 | 5 | 6 | 5 | 7 | 8 | 9 | 6 |
| (A) | (a1-1) Polyimide resin 1 | Production Example 1 | 90 | 85 | 80 | 70 | 60 | 90 | 90 | 80 | 75 | 70 | 60 | 70 | 85 | 70 | 70 |
| (B) | (b1) Zirconium oxide | Zr:KZ-0Y LSF | 10 | 15 | 20 | 30 | 40 | | | 15 | 15 | 20 | 20 | 25 | 5 | 10 | |
| | (b2-1) Silica | SiO2:KS-1 | | | | | | 10 | | | | | | | 5 | 10 | |
| | (b2-2) Talc | Ta:D-800 | | | | | | | 10 | 5 | 10 | 10 | 20 | 5 | 5 | 10 | |
| | (b2-3) Mica | Ma:A-11 | | | | | | | | | | | | | | | 30 |
| Content (parts by mass) of (b1) with respect to 100 parts by mass of (A) | | | 11.1 | 17.6 | 25.0 | 42.9 | 66.7 | 0.0 | 0.0 | 18.8 | 20.0 | 28.6 | 33.3 | 35.7 | 5.9 | 14.3 | 0.0 |
| Content (parts by mass) of (b2) with respect to 100 parts by mass of (A) | | | 0.0 | 0.0 | 0.0 | 0.0 | 0.0 | 11.1 | 11.1 | 6.3 | 13.3 | 14.3 | 33.3 | 7.1 | 11.8 | 28.6 | 42.9 |
| Content (parts by mass) of (B) with respect to 100 parts by mass of (A) | | | 11.1 | 17.6 | 25.0 | 42.9 | 66.7 | 11.1 | 11.1 | 25.0 | 33.3 | 42.9 | 66.7 | 42.9 | 17.6 | 42.9 | 42.9 |
| Content (% by mass of (A) in resin composition | | | 90 | 85 | 80 | 70 | 60 | 90 | 90 | 80 | 75 | 70 | 60 | 70 | 85 | 70 | 70 |
| Content (% by mass) of (b1) in resin composition | | | 10 | 15 | 20 | 30 | 40 | 0 | 0 | 15 | 15 | 20 | 20 | 25 | 5 | 10 | 0 |
| Content (% by mass) of (b2) in resin composition | | | 0 | 0 | 0 | 0 | 0 | 10 | 10 | 5 | 10 | 10 | 20 | 5 | 10 | 20 | 30 |
| Content (% by mass of (B) in resin composition | | | 10 | 15 | 20 | 30 | 40 | 10 | 10 | 20 | 25 | 30 | 40 | 30 | 15 | 30 | 30 |
| Content (% by mass) of (b1) in (B) | | | 100.0 | 100.0 | 100.0 | 100.0 | 100.0 | 0.0 | 0.0 | 75.0 | 60.0 | 66.7 | 50.0 | 83.3 | 33.3 | 33.3 | 0.0 |

(continued)

| (% by mass) | | | Example | | | Comparative Example | | | | Example | | | Comparative Example | Example | | | Comparative Example |
|---|---|---|---|---|---|---|---|---|---|---|---|---|---|---|---|---|---|
| | | | 1 | 2 | 3 | 1 | 2 | 3 | 4 | 4 | 5 | 6 | 5 | 7 | 8 | 9 | 6 |
| Evaluation results | Production stability during twin-screw extrusion | | AA | AA | AA | AA | AA | AA | A | AA | AA | AA | C | AA | AA | A | C |
| | Injection-molding properties | Apparatus load | A | A | A | A | C | A | A | A | A | A | B | A | A | A | A |
| | | Molded article surface roughness | A | A | A | B | C | A | A | A | AA | AA | B | AA | A | A | B |
| | | Molded article burn | A | A | B | B | C | A | A | A | AA | AA | B | AA | A | A | A |
| | Machining processability (1) | Surface roughness during cutting | B | B | A | B | - | C | C | A | A | A | - | B | B | A | C |
| | Microfabricability (1) | Hole size distribution of microholes (100 μm) | A | A | A | C | - | A | A | A | A | A | - | A | A | A | C |
| | | Microhole (100 μm) appearance and burr state | A | A | AA | A | - | C | A | A | AA | AA | - | AA | A | A | C |

Examples 6 and 10 to 12 (Production and evaluation of thermoplastic resin composition and molded article (2))

The component (A) and the component (B) shown in Table 3 were thoroughly mixed by dry blending. The obtained mixed powder was mixed with a co-rotating twin screw extruder ("HK-25D-41D", manufactured by Parker Corporation, screw diameter: 25 mm) at a barrel temperature of 360°C and a screw rotation speed of 120 rpm, and extruded in strands having a diameter of 2 to 3 mm.

The strands extruded from the extruder were air cooled, and then pelletized by a pelletizer ("Fan Cutter FC-Mini-4/N", produced by Hoshi Plastic Co., Ltd.). The obtained pellets (thermoplastic resin composition) were dried at 150°C for 10 hours, and then used for injection-molding.

Injection-molding was performed at a barrel temperature of 375°C, a mold temperature of 200°C, and a molding cycle of 60 seconds with an injection-molding machine ("ROBOSHOT α-S30iA", produced by FANUC Corporation), and a flat plate-like injection-molded article having a thickness of 70 mm × 70 mm × 4 mm was produced.
The injection-molded article was annealed for 60 minutes at the temperature shown in Table 3 using a forced-convection constant-temperature oven (DN610H, manufactured by Yamato Scientific Co., Ltd.), gradually cooled to room temperature, collected, and then evaluated by the following method.

<Machining processability evaluation (2)>

The machining processability of the injection-molded articles that had been subjected to the annealing treatment was evaluated based on the following two items.

(Warpage during cutting)

Injection-molded article obtained by the above method were machined to produce a flat plate measuring 50 mm × 50 mm × 3 mm thick. The state of warpage of the obtained flat plates was checked from eight directions using a strain gauge, and evaluated according to the following criteria.

- A: Warpage of 40 μm or less in all 8 directions.
- B: Warpage exceeding 40 μm in one or more places.
- C: Strong undulations over the whole plate, making it difficult to measure warpage.

(Surface roughness during cutting)

Injection-molded articles obtained by the above method were machined to produce a flat plate of 50 mm × 50 mm × 3 mm thick. On the machined surface of the obtained flat plate, the arithmetic average roughness (Ra) of a continuous area of 20 mm in length was measured in the direction perpendicular to the cutting direction using a 3D shape measuring instrument ("VR-6000", manufactured by Keyence Corporation), and the surface roughness was evaluated according to the following criteria.

- AA: Arithmetic average roughness of 0.3 μm or less
- A: Arithmetic average roughness of more than 0.3 μm and 0.6 μm or less
- B: Arithmetic average roughness of more than 0.6 μm and 1μm or less
- C: Arithmetic average roughness of more than 1 μm

<Microfabricability evaluation (2)>

The microfabricability of the flat plate (machined plate) was evaluated based on the following two items.

(Hole size distribution of microholes (50 μm))

A total of 80 through holes, 4 × 20, were formed at a pitch of 0.1 mm on the area 20 (within an area of approximately 3 mm × 3 mm) near the center of the machined plate 10 of 50 mm × 50 mm × 3 mm thick shown in Fig. 1 using an electric drill (drill diameter: 0.05 mm). The diameter of the formed through holes was measured using a high-precision image dimension measuring instrument ("LM series", manufactured by Keyence Corporation), and evaluated based on the diameter distribution according to the following criteria.

A: Diameter of all through holes between 0.047 and 0.053 mm.
C: Some through holes have diameter exceeding the range of 0.047 and 0.053 mm.

In Table 3, cases where microfabrication itself was difficult are marked with a "-".

(Microhole (50 μm) appearance and burr state)

The appearance of the through holes formed by the above method was observed with a digital microscope ("VHX-7000", manufactured by Keyence Corporation, magnification: 50 times) and evaluated according to the following criteria.

AA: No pattern collapse and few burrs.
A: Some pattern collapse and burrs.
C: Large pattern collapse and holes close together, or a large amount of burrs.

In Table 3, cases where microfabrication itself was difficult are marked with a "-".
The above evaluation results are shown in Table 3. From Table 3, it can be seen that the molded articles of Examples 10 to 12, in which the annealing treatment was performed, had better machining processability and microfabricability than the molded article of Example 6, in which the annealing treatment was not performed.

Table 3

| (% by mass) | | | Example | | | |
|---|---|---|---|---|---|---|
| | | | 6 | 10 | 11 | 12 |
| (A) | (a1-1) Polyimide resin 1 | Production Example 1 | 70 | 70 | 70 | 70 |
| (B) | (b1) Zirconium oxide | Zr:KZ-0Y LSF | 20 | 20 | 20 | 20 |
| | (b2-2) Talc | Ta:D-800 | 10 | 10 | 10 | 10 |
| Content (parts by mass) of (b1) with respect to 100 parts by mass of (A) | | | 28.6 | 28.6 | 28.6 | 28.6 |
| Content (parts by mass) of (b2) with respect to 100 parts by mass of (A) | | | 14.3 | 14.3 | 14.3 | 14.3 |
| Content (parts by mass) of (B) with respect to 100 parts by mass of (A) | | | 42.9 | 42.9 | 42.9 | 42.9 |
| Content (% by mass) of (A) in resin composition | | | 70 | 70 | 70 | 70 |
| Content (% by mass) of (b1) in resin composition | | | 20 | 20 | 20 | 20 |
| Content (% by mass) of (b2) in resin composition | | | 10 | 10 | 10 | 10 |
| Content (% by mass) of (B) in resin composition | | | 30 | 30 | 30 | 30 |
| Content (% by mass) of (b1) in (B) | | | 66.7 | 66.7 | 66.7 | 66.7 |
| Annealing treatment temperature (°C) | | | - | 240 | 280 | 300 |
| Evaluation results | Machining processability evaluation (2) | Warpage during cutting | C | B | A | A |
| | | Surface roughness during cutting | A | A | AA | AA |
| | Microfabricability evaluation (2) | Hole size distribution of microholes (50 μm) | - | C | A | A |
| | | Microhole (50 μm) appearance and burr state | - | C | AA | AA |

The details of each component shown in Tables 2 and 3 are as follows.

<Thermoplastic resin (A)>
(a1-1) Polyimide resin 1 obtained in Production Example 1
<Inorganic filler (B)>

(b1) Zirconium oxide, high purity zirconia "KZ-0Y-LSF", manufactured by KCM Corporation, spherical particles, D50: 0.2 μm, Mohs hardness: 8
(b2-1) Silica, "KS-1", manufactured by KCM Corporation, plate-shaped particles, D50: 1.4 μm, Mohs hardness: 7
(b2-2) Talc, "Nano Ace D-800", manufactured by Nippon Talc Co., Ltd., plate-shaped particles, D50: 0.8 μm, Mohs hardness: 1
(b2-3) Mica, hard mica "A-11" manufactured by Yamaguchi Mica, plate-shaped particles, D50: 3 μm, Mohs hardness: 2.0 to 3.2

Industrial Applicability

According to the thermoplastic resin composition of the present invention, a molded article having excellent machining processability and microfabricability can be produced. The molded article is suitable for producing component part and the like of IC sockets for testing.

Reference Signs List

100: component part of IC socket for inspection
10: machined plate
20: through hole formation area

**Claims**

1. A thermoplastic resin composition comprising:

a component (A), which is at least one thermoplastic resin selected from the group consisting of a crystalline thermoplastic resin (a1) having a melting point of 270°C or more and an amorphous thermoplastic resin (a2) having a glass transition temperature of 200°C or more; and
a component (B), which is an inorganic filler comprising a zirconium oxide (b1),

wherein

a content of the component (b1) is 2 to 40 parts by mass with respect to 100 parts by mass of the component (A), and
a content of the component (B) is 2 to 60 parts by mass based on 100 parts by mass of the component (A).

2. The thermoplastic resin composition according to claim 1, wherein the component (A) is at least one selected from the group consisting of a polyimide resin, a polyetherimide resin, a polyetherimide sulfone resin, a polyphenylene sulfide resin, a polyether ether ketone resin, a polyether ketone ketone resin, a liquid crystal polymer, and a wholly aromatic polyester resin other than a liquid crystal polymer.

3. The thermoplastic resin composition according to claim 1 or 2, wherein the component (A) comprises a polyimide resin (a1-1) comprising a repeating structural unit represented by the following formula (1) and a repeating structural unit represented by the following formula (2), a content ratio of the repeating structural unit of formula (1) to the total of the repeating structural unit of formula (1) and the repeating structural unit of formula (2) being 20 to 70 mol%:

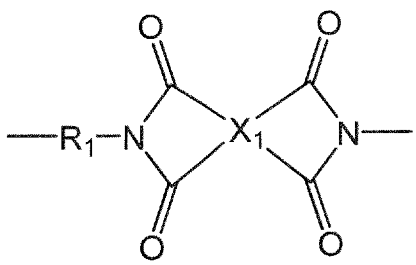

(1)

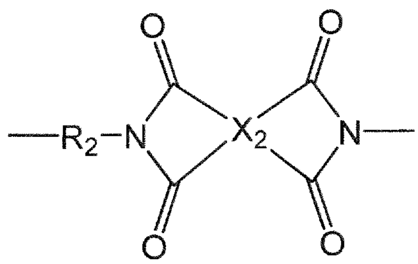

(2)

wherein $R_1$ represents a divalent group having from 6 to 22 carbon atoms containing at least one alicyclic hydrocarbon structure; $R_2$ represents a divalent chain aliphatic group having from 5 to 16 carbon atoms; and $X_1$ and $X_2$ each independently represent a tetravalent group having from 6 to 22 carbon atoms containing at least one aromatic ring.

**4.** The thermoplastic resin composition according to any one of claims 1 to 3, wherein the component (b1) has a volume median diameter (D50) of 1 μm or less.

**5.** The thermoplastic resin composition according to any one of claims 1 to 4, wherein the component (b1) is a spherical particle.

**6.** The thermoplastic resin composition according to any one of claims 1 to 5, wherein the component (B) further comprises an inorganic filler (b2) other than the component (b1), and the component (b2) is at least one selected from the group consisting of talc, mica, silica, alumina, silicon nitride, aluminum nitride, boron nitride, silicon carbide, boron carbide, calcium carbonate, and titanium oxide.

**7.** The thermoplastic resin composition according to claim 6, wherein a content of the component (b2) is 1 to 40 parts by mass with respect to 100 parts by mass of the component (A).

**8.** A molded article comprising the thermoplastic resin composition according to any one of claims 1 to 7.

**9.** A component part of an IC socket for inspection obtained by processing the molded article according to claim 8.

[Fig. 1]

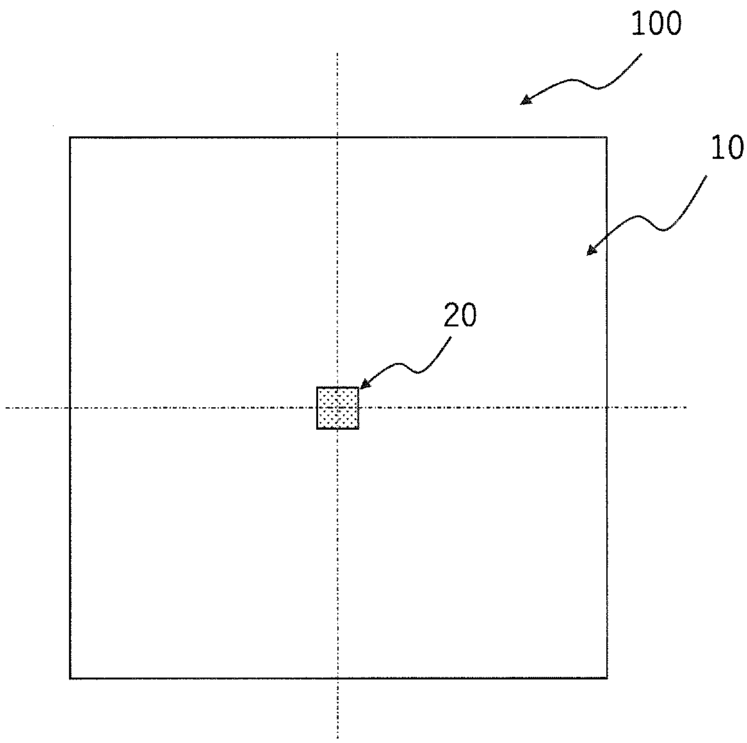

## INTERNATIONAL SEARCH REPORT

International application No.
**PCT/JP2023/021667**

### A. CLASSIFICATION OF SUBJECT MATTER

***C08L 101/00***(2006.01)i; ***C08L 79/08***(2006.01)i; ***C08K 3/013***(2018.01)i; ***C08K 3/22***(2006.01)i
FI: C08L101/00; C08K3/013; C08K3/22; C08L79/08

According to International Patent Classification (IPC) or to both national classification and IPC

### B. FIELDS SEARCHED

Minimum documentation searched (classification system followed by classification symbols)

C08L101/00; C08L79/08; C08K3/013; C08K3/22

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2016-75894 A (KONICA MINOLTA INC) 12 May 2016 (2016-05-12) paragraph [0252], tables 1, 3, etc. | 1-5, 8 |
| A | JP 2018-53156 A (KONICA MINOLTA INC) 05 April 2018 (2018-04-05) | 1-9 |
| A | WO 2017/175679 A1 (MITSUBISHI GAS CHEMICAL COMPANY, INC.) 12 October 2017 (2017-10-12) | 1-9 |

☐ Further documents are listed in the continuation of Box C.　　☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **14 July 2023** | **01 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/021667**

| Patent document cited in search report | Publication date (day/month/year) | Patent family member(s) | Publication date (day/month/year) |
|---|---|---|---|
| JP 2016-75894 A | 12 May 2016 | (Family: none) | |
| JP 2018-53156 A | 05 April 2018 | (Family: none) | |
| WO 2017/175679 A1 | 12 October 2017 | US 2020/0002477 A1<br>EP 3441428 A1<br>CN 108884317 A<br>KR 10-2018-0124890 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005290328 A
- WO 2021024624 A1
- JP 2018529932 A
- WO 2016147996 A